# DEMANDE DE BREVET EUROPEEN

(11) **EP 4 152 373 A2**
(43) Date de publication de la demande: **22.03.2023**
(21) Numéro de dépôt: 22191722.2
(22) Date de dépôt: 23.08.2022
(51) Int. Cl.: H01L 23/00, H01L 25/00

(54) **PROCEDE DE FABRICATION D'UN CIRCUIT ELECTRONIQUE POUR AUTO-ASSEMBLAGE A UN AUTRE CIRCUIT ELECTRONIQUE**

(30) Priorité: 27.08.2021 FR 2108992
(71) Demandeur: Commissariat à l'énergie atomique et aux énergies alternatives, 75015 Paris (FR)
(72) Inventeur: BOND, Alice, 38054 GRENOBLE CEDEX 09 (FR); BOURJOT, Emilie, 38054 GRENOBLE CEDEX 09 (FR)
(74) Mandataire: Cabinet Beaumont

(57) **Abrégé**

La présente description concerne un procédé de fabrication d'un circuit électronique (30) comprenant :
- un support (32),
- un site d'assemblage (31) présentant une première surface protubérante par rapport audit support destinée à être assemblé à un site d'assemblage d'un autre circuit électronique par un procédé d'auto-assemblage, et
- une zone périphérique (39) autour dudit site d'assemblage, le site d'assemblage (31) comportant au moins un niveau, chaque niveau comportant des plots conducteurs (34) et des poteaux isolants (380) entre les plots conducteurs, ;
ledit procédé de fabrication comprenant la formation dudit au moins un niveau du site d'assemblage, les bords, dans au moins une direction (X) du plan principal (XY), de chaque niveau du site d'assemblage et les emplacements, dans la au moins une direction (X), des plots conducteurs et des poteaux isolants du même niveau étant définis en une même étape de photolithographie dudit procédé.

## Description

### Domaine technique

La présente description concerne de façon générale l'intégration tridimensionnelle de composants microélectroniques, et concerne plus particulièrement la fabrication de circuits électroniques aptes à être assemblés l'un sur l'autre par un procédé d'auto-assemblage.

### Technique antérieure

Pour réaliser l'intégration tridimensionnelle de composants microélectroniques, plusieurs techniques existent, et en particulier l'approche dite « puce à plaque » (« Die-to-Wafer » en anglais). Cette technique vise à utiliser les puces fonctionnelles d'une plaque et à les reporter, après découpe, sur une autre plaque qui peut également être préalablement fonctionnalisée, c'est-à-dire préparée en vue de son assemblage avec la puce.

L'alignement de puces sur une plaque peut être obtenu avec des machines robotisées permettant le prélèvement et le positionnement des puces, une à une, pour leur assemblage sur la plaque. Cette technique et les machines associées sont connues sous la terminologie anglo-saxonne « pick-and-place ». Cependant, du fait de la baisse des dimensions en intégration tridimensionnelle, induisant une augmentation de l'exigence de la précision d'alignement entre la puce et la plaque (par exemple erreur d'alignement inférieure à 1 µm voire à 0,5 µm), combinée avec des exigences de cadence d'assemblage (par exemple supérieure à 10000 puces par heure), cette technique devient de moins en moins adaptée. En outre, sa mise en oeuvre implique l'utilisation de machines généralement coûteuses et complexes.

Les techniques d'auto-assemblage sont de plus en plus envisagées comme alternatives ou en complément à la robotique, et notamment à la technique pick-and-place.

Un procédé d'auto-assemblage connu, permettant d'aligner puis d'assembler un circuit électronique sur un support, consiste à utiliser un fluide comme média d'auto-alignement, notamment une goutte de liquide.

Le circuit électronique à assembler peut être une puce (« die » ou « chip » en anglais) et correspondre à un circuit intégré. Le support correspond généralement à un autre circuit électronique, qui peut être une puce de circuit intégré ou une plaque de circuits intégrés, qui peut être désignée par raccourci par le terme « plaque » (« wafer » en anglais).

Un procédé d'auto-assemblage d'un circuit électronique sur un support peut être basé sur le confinement d'une goutte d'un liquide, par exemple de l'eau, sur une surface à forte mouillabilité (que l'on peut désigner par surface « hydrophile ») située sur le support et correspondant à l'emplacement souhaité du circuit électronique. Le circuit électronique peut ensuite être disposé sur la goutte de liquide, ce qui permet son alignement vis-à-vis de son emplacement sur le support.

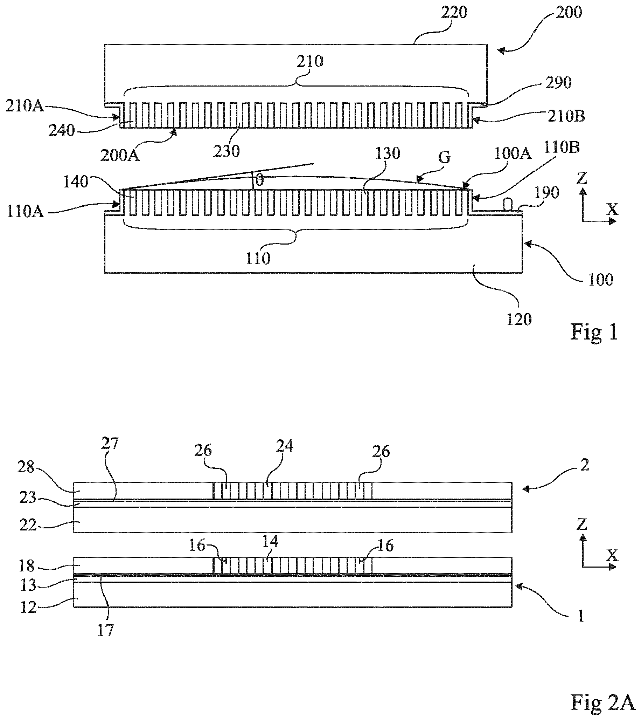

La surface à forte mouillabilité peut être entourée d'une surface à faible mouillabilité (que l'on peut désigner par surface « hydrophobe »), afin de favoriser le confinement de la goutte de liquide sur la surface hydrophile. La mouillabilité d'un matériau peut être caractérisée par l'angle de contact θ (visible sur la figure 1) d'une goutte de liquide sur le matériau (l'angle θ est visible sur la figure 1). Plus l'angle de contact est faible, plus la mouillabilité du matériau est élevée.

La figure 1 représente un exemple de support 100 et de circuit électronique 200 adaptés pour être assemblés l'un à l'autre par un procédé d'auto-assemblage.

Le support 100 présente sur sa face supérieure 100A un site d'assemblage 110 à forte mouillabilité entourée par une zone périphérique 190 à faible mouillabilité. Par exemple, les bords 110A, 110B du site d'assemblage 110 forment une marche par rapport à la zone périphérique 190. Le site d'assemblage 110 forme une protubérance sur un substrat 120 et comporte plusieurs plots conducteurs 140 affleurant en surface et séparés par des poteaux isolants 130.

De la même manière que le support 100, le circuit électronique 200 comporte au niveau de sa face avant 200A, qui correspond à la face destinée à être solidarisée à la face supérieure 100A du support 100, un site d'assemblage 210 protubérant, dont les dimensions correspondent sensiblement à celles du site d'assemblage 110 du support. Le site d'assemblage 210 est entouré par une zone périphérique 290 à faible mouillabilité. Par exemple, les bords 210A, 210B du site d'assemblage 210 forment une marche par rapport à la zone périphérique 290 qui peut correspondre aussi aux bords du circuit électronique 200. De même que pour le support 100, le site d'assemblage est disposé sur un substrat 220 et comporte des plots conducteurs 240 affleurant en surface et séparés par des poteaux isolants 23H0.

Pour assembler le circuit électronique 200 au support 100, une goutte G d'un liquide, par exemple de l'eau, est disposée sur le site d'assemblage 110 du support. Le circuit électronique 200 est alors approché du site d'assemblage 110 jusqu'à ce que son site d'assemblage 210 vienne au contact de la goutte. Dans cette phase d'approche, le circuit électronique peut être décalé voire incliné par rapport à la zone d'assemblage. Les forces exercées par la goutte sur le circuit électronique déplacent alors le circuit électronique 200 jusqu'à l'alignement souhaité par rapport au site d'assemblage 110, généralement sans qu'aucune action extérieure ne soit nécessaire. Une fois le circuit électronique aligné sur le support, une étape de fixation du circuit électronique au support peut être mis en œuvre, après évaporation du liquide. Par convention, on considère que l'étape de fixation est une étape comprise dans le procédé d'auto-assemblage.

Pour certaines applications, l'étape de fixation peut comprendre, ou consister en, une étape de thermocompression ou de collage moléculaire. Le collage moléculaire (ou « collage direct ») est induit par l'ensemble des forces attractives d'interaction électronique entre les atomes ou molécules des deux surfaces à coller et permet ainsi de solidariser les deux surfaces via une mise en contact direct sans faire appel à un matériau de collage.

En particulier, on cherche à réaliser une étape de fixation hybride dans un procédé d'auto-assemblage, permettant d'assembler un circuit électronique sur un support, tout en assurant une interconnexion électrique entre le circuit électronique et le support. Par raccourci, on pourra parler, dans l'ensemble de la présente description, de procédé d'auto-assemblage hybride. En particulier, l'étape de fixation peut comprendre, ou consister en, une étape de collage moléculaire hybride.

Dans l'exemple représenté, un procédé d'auto-assemblage hybride doit permettre de fixer le circuit électronique 200 au support 100 en alignant non seulement les sites d'assemblage 110, 210 l'un par rapport à l'autre, mais également pour mettre en contact les plots conducteurs 240 du circuit électronique 200 avec les plots conducteurs 140 du support 100.

Toutefois, avec les procédés d'auto-assemblage connus, il peut être difficile de réaliser un alignement correct des sites d'assemblage, tout en respectant l'alignement des plots conducteurs. Cette exigence d'alignement des plots est encore plus cruciale lorsque les pas entre les plots conducteurs diminuent et/ou que la largeur des plots conducteurs diminue.

Il existe donc le besoin d'une solution permettant d'auto-assembler un circuit électronique sur un autre circuit électronique, qui permette l'alignement des circuits électroniques l'un par rapport à l'autre tout en assurant l'alignement de plots conducteurs du circuit électronique avec ceux de l'autre circuit électronique, et ce, quelques soient les pas entre les plots conducteurs et/ou les largeurs desdits plots conducteurs.

Il est, en outre, souhaitable que la solution soit compatible avec les techniques classiques de fabrication et/ou d'assemblage de circuits électroniques.

### Résumé de l'invention

Un objet d'un mode de réalisation est de pallier tout ou partie des inconvénients des solutions connues d'auto-assemblage, en proposant un procédé de fabrication d'un circuit électronique adapté pour être assemblé par un procédé d'auto-assemblage avec fixation hybride à un autre circuit électronique.

Un mode de réalisation prévoit un procédé de fabrication d'un circuit électronique s'étendant selon un plan principal et comprenant :
- un support,
- un site d'assemblage sur ledit support, ledit site d'assemblage présentant une première surface protubérante par rapport audit support destinée à être assemblée à un site d'assemblage d'un autre circuit électronique par un procédé d'auto-assemblage, et
- une zone périphérique autour dudit site d'assemblage ;

le site d'assemblage comportant au moins un niveau, chaque niveau comportant des plots conducteurs et des poteaux isolants entre les plots conducteurs, lesdits plots conducteurs et lesdits poteaux isolants affleurant à ladite première surface dudit site d'assemblage ;
ledit procédé de fabrication comprenant la formation dudit au moins un niveau du site d'assemblage ; les bords, dans au moins une direction du plan principal, de chaque niveau du site d'assemblage et les emplacements, dans la au moins une direction, des plots conducteurs et des poteaux isolants du même niveau étant définis en une même étape de photolithographie dudit procédé ; ladite étape de photolithographie étant adaptée à former un motif en résine dimensionné pour former, après une étape de gravure à partir d'une face d'une structure recouverte par ledit motif, lesdits bords et lesdits emplacements.

Selon un mode de réalisation, le procédé de fabrication comprend, pour chaque niveau du site d'assemblage, une étape de gravure, ultérieure à l'étape de photolithographie, ladite étape de gravure étant réalisée à partir de la face de la structure recouverte par le motif en résine formant masque de gravure.

Selon un mode de réalisation, le motif en résine formé pour chaque niveau du site d'assemblage est dimensionné pour que les poteaux isolants comprennent des poteaux isolants aux bords du site d'assemblage plus larges dans la au moins une direction du plan principal que les poteaux isolants situés entre lesdits bords.

Selon un mode de réalisation, le motif en résine formé pour au moins le premier niveau du site d'assemblage est dimensionné pour former sur la zone périphérique du support des poteaux complémentaires dans la couche isolante.

Selon un mode de réalisation particulier, les poteaux complémentaires sont configurés pour diminuer la mouillabilité de la zone périphérique par rapport à la mouillabilité du site d'assemblage. Par exemple, les poteaux complémentaires présentent une largeur dans une direction du plan principal comprise entre 0,5 µm et 1 µm, une hauteur comprise entre 50 nm et 2 µm, et deux poteaux complémentaires adjacents sont distants d'un écartement compris entre 0,5 µm et 2 µm dans ladite direction.

Selon un mode de réalisation, la formation d'un premier niveau du site d'assemblage comprend :
- une étape de formation d'une couche isolante en un premier matériau diélectrique sur le support ; puis
- une étape de photolithographie adaptée pour former un motif en résine sur la couche isolante ; puis
- une étape de gravure depuis la face de la couche isolante recouverte par le motif formant masque de gravure, de manière à former une pluralité de tranchées dans ladite couche isolante séparées entre elles par des poteaux isolants en le premier matériau diélectrique ; puis
- une étape de retrait du motif ; puis
- une étape de formation d'une couche conductrice en un premier matériau conducteur sur la face gravée de la couche isolante de manière à au moins remplir les tranchées, le premier matériau conducteur inséré dans les tranchées formant des plots conducteurs séparés entre eux par les poteaux isolants ; puis
- une étape de polissage, par exemple mécanochimique, de la couche conductrice, ladite étape de polissage étant adaptée à faire affleurer les plots conducteurs au même niveau que les poteaux isolants de la couche isolante gravée.

Le premier matériau conducteur est par exemple du cuivre ou du cobalt.

Selon un mode de réalisation, la formation d'un premier niveau du site d'assemblage comprend :
- une étape de formation d'une couche conductrice en un deuxième matériau conducteur sur le support ; puis
- une étape de photolithographie adaptée pour former un motif en résine sur la couche conductrice ; puis
- une étape de gravure depuis la face de la couche conductrice recouverte par le motif formant masque de gravure, de manière à former une pluralité de tranchées dans la couche conductrice et des plots conducteurs en le deuxième matériau conducteur séparés entre eux par lesdites tranchées ; puis
- une étape de retrait du motif ; puis
- une étape de formation d'une couche isolante en un deuxième matériau diélectrique sur la face gravée de la couche conductrice de manière à au moins remplir les tranchées, le deuxième matériau diélectrique inséré dans lesdites tranchées formant des poteaux isolants isolant les plots conducteurs entre eux ; puis
- une étape de polissage, par exemple mécanochimique, de la couche isolante, ladite étape de polissage étant adaptée à faire affleurer les poteaux isolants au niveau des plots conducteurs.

Le deuxième matériau conducteur est par exemple de l'aluminium, du tungstène, ou un alliage à base d'aluminium et de cuivre ou d'aluminium et de silicium.

Selon un mode de réalisation, la formation du premier niveau du site d'assemblage comprend, préalablement à l'étape de formation de la couche isolante en le premier matériau diélectrique ou de la couche conductrice en le deuxième matériau conducteur, une étape de formation d'une couche d'arrêt de gravure sur le support, par exemple une couche en nitrure de silicium.

Selon un mode de réalisation, les étapes de formation du premier niveau du site d'assemblage sont réitérées au moins une fois de manière à former un autre niveau de site d'assemblage comprenant d'autres plots conducteurs et d'autres poteaux isolants, lesdits autres plots conducteurs, respectivement lesdits autres poteaux isolants, étant disposés au droit des plots conducteurs, respectivement des poteaux isolants, du niveau du site d'assemblage précédemment formé. Selon un exemple, ledit procédé comprend une étape préalable de formation d'une couche d'arrêt de gravure sur le niveau du site d'assemblage précédemment formé.

Selon un mode de réalisation, le procédé de fabrication comprend une étape complémentaire de photolithographie adaptée à recouvrir le site d'assemblage d'un motif complémentaire en résine, ledit motif complémentaire débordant d'une dimension par exemple comprise entre 1 nm et 1 µm, par exemple 300 nm, de part et d'autre dudit site d'assemblage au-dessus de la zone périphérique.

Selon un mode de réalisation particulier, le procédé de fabrication comprend, ultérieurement à l'étape complémentaire de photolithographie, une étape complémentaire de gravure, de préférence humide, d'une partie de la au moins une couche conductrice localisée sur la zone périphérique.

Selon un mode de réalisation particulier, le procédé de fabrication comprend une étape, ultérieure à l'étape complémentaire de photolithographie et, le cas échéant, à l'étape complémentaire de gravure, de formation d'une couche, d'épaisseur par exemple comprise entre 1 et 300 nm, en un matériau hydrophobe sur la zone périphérique, le matériau hydrophobe étant par exemple un matériau fluoré, de préférence fluorocarboné.

Un mode de réalisation prévoit un circuit électronique s'étendant selon un plan principal et comprenant :
- un support ;
- un site d'assemblage sur ledit support, ledit site d'assemblage présentant une première surface protubérante par rapport audit support destinée à être assemblé à un site d'assemblage d'un autre circuit électronique par un procédé d'auto-assemblage ; et
- une zone périphérique tout autour dudit site d'assemblage ;

le site d'assemblage comportant au moins un niveau, chaque niveau comportant des plots conducteurs et des poteaux isolants entre les plots conducteurs, lesdits plots conducteurs et lesdites poteaux isolants affleurant à ladite première surface dudit site d'assemblage ;
les bords, dans au moins une direction du plan principal, de chaque niveau du site d'assemblage et les emplacements, dans la au moins une direction, des plots conducteurs et des poteaux isolants du même niveau étant définis en une même étape de photolithographie, adaptée à former un motif en résine dimensionné pour former, après une étape de gravure à partir d'une face d'une structure recouverte par ledit motif, lesdits bords et lesdits emplacements ;
les bords du site d'assemblage, dans la au moins une direction du plan principal, comportant des poteaux isolants.

Un mode de réalisation prévoit un procédé d'auto-assemblage d'un premier circuit électronique et d'un deuxième circuit électronique, les premier et deuxième circuits électroniques étant fabriqués par le procédé de fabrication selon un mode de réalisation, le procédé d'auto-assemblage comprenant :
- une étape de dépôt d'une goutte d'un liquide sur la première surface du site d'assemblage du premier circuit électronique ; puis
- la mise en contact de la première surface du site d'assemblage du deuxième circuit électronique avec la première surface du site d'assemblage, revêtue de la goutte de liquide, du premier circuit électronique ; puis
- une étape de fixation, par exemple par collage moléculaire hybride ou thermocompression, du site d'assemblage du deuxième circuit électronique au site d'assemblage du premier circuit électronique.

Selon un mode de réalisation, le deuxième circuit électronique est découpé de manière à former une puce de circuit intégré, préalablement à l'étape de mise en contact, le premier circuit électronique étant une plaque de circuits intégrés.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un exemple de circuit électronique et de support destinés à être assemblés par un procédé d'auto-assemblage ;
la figure 2A, la figure 2B, la figure 2C et la figure 2D sont des vues en coupe illustrant un procédé d'auto-assemblage d'un circuit électronique sur un support ;
la figure 3A, la figure 3B, la figure 3C, la figure 3D, la figure 3E et la figure 3F sont des vues en coupe illustrant un procédé de fabrication d'un circuit électronique selon un mode de réalisation ;
la figure 3G est une vue en coupe illustrant un procédé d'auto-assemblage de deux circuits électroniques obtenus par le procédé de fabrication des figures 3A à 3F ;
la figure 3H est une vue de dessus du circuit électronique obtenu par le procédé des figures 3A à 3F ;
la figure 4A, la figure 4B et la figure 4C sont des vues en coupe illustrant un procédé de fabrication d'un circuit électronique selon un autre mode de réalisation ;
la figure 5 représente une variante du procédé de fabrication des figures 4A à 4C ;
la figure 6A et la figure 6B sont des vues en coupe illustrant un procédé de fabrication d'un circuit électronique selon un autre mode de réalisation ;
la figure 7A, la figure 7B, la figure 7C et la figure 7D sont des vues en coupe illustrant un procédé de fabrication d'un circuit électronique selon un autre mode de réalisation ;
la figure 8A, la figure 8B, la figure 8C et la figure 8D sont des vues en coupe illustrant un procédé de fabrication d'un circuit électronique selon un autre mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

En particulier, on a représenté essentiellement la partie de chaque circuit électronique, dite partie arrière (« Back End Of Line » ou « BEOL » en anglais), correspondant à la partie où les composants du circuit électronique sont interconnectés entre eux et/ou peuvent être interconnectés avec un autre circuit électronique, grâce à un ou plusieurs niveaux de métallisation. Le BEOL d'un circuit électronique comprend généralement au moins une couche isolante dans laquelle sont formés des pistes métalliques d'un ou plusieurs niveaux de métallisation et des vias conducteurs pour relier les composants électroniques entre eux (non représentés dans les figures), ainsi que des plots conducteurs de connexion adaptés pour relier le circuit électronique avec un autre circuit électronique. Sous le BEOL, le circuit électronique comprend généralement au moins un substrat dans et/ou sur lequel sont formés des composants électroniques, qui ne sont pas représentés dans les figures.

En outre, certaines étapes du procédé de fabrication (par exemple des étapes de formation de couche, des étapes de photolithographie, des étapes de retrait de résine, des étapes de gravure...) ne sont pas détaillées, ces étapes étant à la portée de la personne du métier qui peut mettre en œuvre des techniques courantes de fabrication de circuits électroniques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un circuit électronique en considérant que la BEOL est en partie supérieure.

Dans l'ensemble de la présente description, une hauteur ainsi qu'une épaisseur désignent une dimension dans une direction verticale (direction Z identifiée dans les figures), une largeur désigne une dimension selon la direction X identifiée dans les figures. Un pas, ou un écartement, désigne dans les figures une dimension selon la direction X. Un pas, ou un écartement, peut également correspondre à une dimension selon la direction Y perpendiculaire aux directions X et Z. Les directions X et Y forment un plan XY désigné comme étant le plan principal d'un circuit électronique.

Sauf précision contraire, les expressions "environ", "approximativement", "sensiblement", et "de l'ordre de" signifient à 10 % près, de préférence à 5 % près.

Dans l'ensemble de la présente description, un matériau "hydrophile" désigne un matériau à forte mouillabilité, et un matériau "hydrophobe" désigne un matériau à faible mouillabilité. De façon générale, la mouillabilité d'un matériau peut être caractérisée par l'angle de contact statique d'une goutte de liquide sur le matériau. Plus l'angle de contact est faible, plus la mouillabilité du matériau est élevée. On peut considérer qu'un matériau à forte mouillabilité est un matériau pour lequel l'angle de contact statique d'une goutte du liquide sur le matériau est inférieur à 90° et qu'un matériau à faible mouillabilitéest un matériau pour lequel l'angle de contact statique d'une goutte du liquide sur le matériau est supérieur à 90°. La mesure de l'angle de mouillage peut être réalisée en utilisant l'appareil de mesure commercialisé par la société GBX sous l'appellation Digidrop - MCAT.

Un procédé Damascène comprend la fourniture d'ouvertures dans une couche continue d'un premier matériau puis une étape de dépôt d'un deuxième matériau pour combler ces ouvertures, puis une étape de polissage (ou "planarisation") de la surface de sorte à former une surface sensiblement plane où affleurent les premier et deuxième matériaux.

Les figures 2A à 2D représentent des étapes d'un procédé d'auto-assemblage d'un circuit électronique, par exemple une puce, sur un autre circuit électronique, par exemple une plaque.

La figure 2A représente deux circuits électroniques 1, 2, pouvant être des plaques de circuits intégrés. Chaque circuit électronique 1, 2 représenté comprend un substrat 12, 22, par exemple en silicium (Si), sur lequel est disposée au moins une première couche 13, 23 en matériau diélectrique, par exemple en dioxyde de silicium (SiO₂). Une couche d'arrêt de gravure 17, 27, par exemple en nitrure de silicium (SiₓN_{y}) est disposée sur la première couche 13, 23 en matériau diélectrique. Une deuxième couche 18, 28 en matériau diélectrique, par exemple en dioxyde de silicium (SiO₂), est disposée sur la couche d'arrêt 17, 27. Plusieurs plots conducteurs 14, 24 s'étendent sensiblement verticalement dans la deuxième couche 18, 28 en matériau diélectrique jusqu'à la couche d'arrêt de gravure 17, 27 et affleurent sur la face supérieure de ladite deuxième couche. Ainsi deux plots conducteurs 14, 24 adjacents sont séparés par le matériau diélectrique de la deuxième couche 18, 28.

Sur la figure 2A, les largeurs des plots conducteurs 14, 24 sont sensiblement toutes égales et les écartements entre deux plots adjacents sont sensiblement tous égaux. Il est possible cependant d'avoir sur un même site d'assemblage, différentes zones ayant chacune une taille de plots conducteurs et un écartement entre plots propres. On parle alors de "multi pitch".

Des repères d'alignement 16, 26 ont été formés dans chacun des deux circuits électroniques 1, 2. Les repères 16, 26 sont par exemple positionnés dans la deuxième couche en diélectrique 18, 28 de chaque circuit électronique, entre deux plots conducteurs 14, 24. Les repères d'alignement 16, 26 sont positionnés de manière symétrique entre le premier et le deuxième circuit électronique.

Les plots conducteurs 14, 24 représentés sont par exemple en cuivre (Cu). Ils peuvent être formés par un procédé Damascène, comprenant une étape de gravure de la deuxième couche en diélectrique jusqu'à la couche d'arrêt de gravure afin de former des tranchées et/ou des trous dans ladite deuxième couche, généralement précédée d'une étape de photolithographie pour définir un motif en résine formant masque de gravure, puis une étape de dépôt de cuivre pour combler les tranchées et/ou les trous, puis une étape de polissage (ou "planarisation") de la surface supérieure du circuit électronique de sorte que les plots conducteurs affleurent au même niveau que la face supérieure de la deuxième couche en diélectrique.

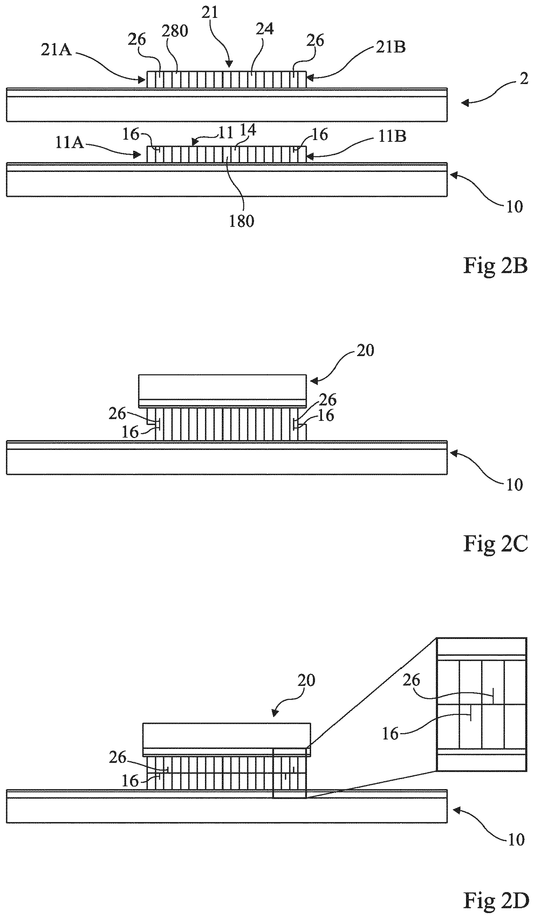

La figure 2B représente une étape suivante dans laquelle la deuxième couche en diélectrique 18, 28 de chaque circuit électronique 1, 2 a été gravée de part et d'autre de la série de plots conducteurs 14, 24 afin de former un site d'assemblage 11, 21 intégrant lesdits plots conducteurs. De la deuxième couche en diélectrique ne restent que des poteaux 180, 280 en diélectrique agencés entre deux plots conducteurs 14, 24, ou contre un seul plot conducteur. Cette étape de gravure est généralement précédée d'une étape de photolithographie afin de définir le positionnement et les dimensions de la gravure, et ainsi le positionnement et les dimensions du site d'assemblage. Par exemple, les dimensions, et notamment les largeurs, des deux sites d'assemblage 11, 21 sont sensiblement égales entre elles.

Le premier circuit électronique ainsi préparé peut former une plaque 10 fonctionnalisée pour un procédé d'auto-assemblage avec une puce 20.

Après l'étape 2B, le deuxième circuit électronique 2 est découpé afin de former une puce 20 puis celle-ci est retournée afin qu'elle puisse être alignée puis assemblée à la plaque 10.

Une solution, représentée dans la figure 2C, pour aligner la puce 20 sur la plaque 10, généralement utilisée dans la technique pick and place, est de contrôler l'alignement des repères 26 de la puce 20 par rapport aux repères 16 de la plaque 10 à l'aide d'une caméra afin de permettre d'aligner les plots conducteurs 14 de la plaque 10 avec les plots conducteurs 24 de la puce 20. Cette solution peut générer un décalage entre le site d'assemblage 11 de la plaque 10 et le site d'assemblage 21 de la puce 20, comme on peut le voir sur la figure 2C. Une telle solution n'est pas réalisable dans un procédé d'auto-assemblage.

Une autre solution, représentée dans la figure 2D, plus adaptée à un procédé d'auto-assemblage, est d'aligner les bords 11A, 11B du site d'assemblage 11 de la plaque 10 avec les bords 21A, 21B du site d'assemblage 21 de la puce 20. Cependant, cette solution peut conduire à un désalignement entre les plots conducteurs 14 de la plaque 10 et les plots conducteurs 24 de la puce 20, comme on peut le voir sur la figure 2D. Avec un tel désalignement des plots conducteurs, l'interconnexion entre la puce et la plaque une fois assemblés peut ne pas être assurée.

Ce désalignement est dû au fait que chaque site d'assemblage avec des plots conducteurs est formé à l'aide de deux niveaux de photolithographie/gravure, comme expliqué plus avant : un premier niveau pour former les plots conducteurs puis un deuxième niveau pour former le site d'assemblage. Or, au cours du procédé de fabrication du site d'assemblage, et en particulier du fait des deux niveaux de photolithographie/gravure, un désalignement peut se produire dans la direction X (et/ou dans la direction Y), notamment dû à des transformations des couches sous-jacentes. Un tel désalignement entre deux niveaux de photolithographie peut atteindre environ 250 nm pour un circuit électronique, 500 nm lorsqu'on superpose deux circuits électroniques. Cela induit une limite technologique à la diminution de la largeur des plots conducteurs et du pas d'interconnexion (écartement entre deux plots conducteurs).

Les inventrices ont proposé un procédé de fabrication de circuit électronique destiné à être assemblé à un autre circuit électronique par un procédé d'auto-assemblage, permettant de pallier tout ou partie des inconvénients susmentionnés.

Des exemples de mise en œuvre de procédés de fabrication vont être décrits ci-après. Ces exemples sont non limitatifs et diverses variantes apparaîtront à la personne du métier à partir des indications de la présente description.

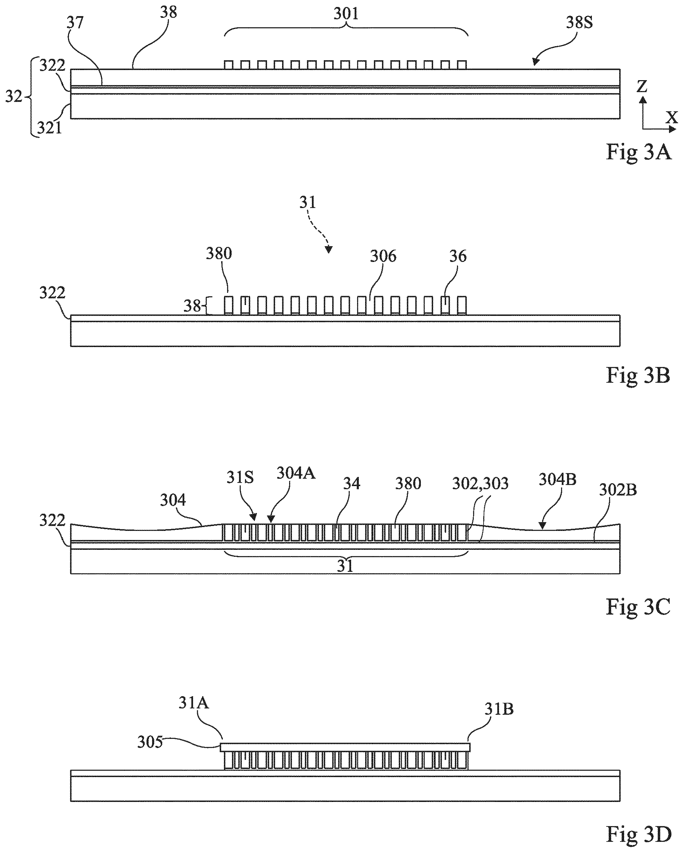

Les figures 3A à 3F sont des vues en coupe illustrant un procédé de fabrication, mettant en œuvre un procédé Damascène, d'un circuit électronique 30 destiné à être assemblé par un procédé d'auto-assemblage à un autre circuit électronique obtenu par un procédé de fabrication selon un, de préférence le même, mode de réalisation.

La figure 3A illustre une structure de départ 32 (support). Elle comprend un substrat 321 revêtu d'une couche initiale en matériau diélectrique 322 d'épaisseur typiquement comprise entre environ 50 nm et 2 µm, par exemple égale à environ 500 nm. Le substrat est par exemple en silicium (Si) avec une épaisseur comprise entre environ 300 µm et 2000 µm, par exemple égale à environ 725 µm. Le matériau diélectrique de la couche initiale est par exemple en dioxyde de silicium (SiO₂).

Dans l'ensemble de la description, une couche en matériau diélectrique peut également être désignée par "couche isolante". Une couche isolante peut être une monocouche ou avoir une structure multicouches comprenant un empilement de couches isolantes.

La couche initiale en matériau diélectrique 322 est recouverte d'une couche d'arrêt de gravure 37 par exemple en nitrure de silicium (SiₓN_{y}). Son épaisseur est par exemple comprise entre environ 5 et 300 nm, par exemple égale à environ 70 nm.

La couche d'arrêt de gravure 37 est recouverte d'une couche 38 en matériau diélectrique, par exemple en dioxyde de silicium (SiO₂) et d'épaisseur typiquement comprise entre environ 100 nm et 2 µm, par exemple égale à environ 500 nm.

On réalise, dans cet exemple par photolithographie, sur la couche isolante 38 un motif 301 en résine formé d'une succession de créneaux pleins (parties pleines) séparés par des trous.

La figure 3B illustre la structure obtenue après gravure de la couche isolante 38 à travers un premier masque de gravure formé par le motif 301 avec arrêt sur la couche d'arrêt de gravure 37, retrait du motif 301 puis gravure de la couche d'arrêt de gravure 37 à travers la couche isolante 38 gravée.

On obtient ainsi une pluralité de poteaux 380 en matériau diélectrique (correspondant aux créneaux du motif) et de tranchées 306 entre lesdits poteaux (correspondant aux trous du motif). Les contours du motif 301, ainsi que des poteaux isolants parmi la pluralité de poteaux isolants 380, définissent les contours (bords) du futur site d'assemblage 31 (repéré en pointillés dans la figure 3B car non finalisé à cette étape du procédé) du circuit électronique, ainsi que les emplacements des futurs plots conducteurs 34 qui seront réalisés dans les tranchées 306.

Ainsi, les bords du site d'assemblage et les emplacements des plots conducteurs dans ledit site d'assemblage (le terme "emplacements" incluant des dimensions dans au moins une direction du plan principal XY) sont définis lors de cette étape de photolithographie, c'est-à-dire avec un même niveau de photolithographie. Les bords et les emplacements sont définis dans au moins la direction X du plan principal XY, mais peuvent être également définis dans la direction Y du plan principal.

De manière optionnelle, des repères d'alignement 36 sont formés dans un ou plusieurs des poteaux isolants 380.

La figure 3C illustre la formation des plots conducteurs 34 au niveau des tranchées 306.

Pour cela, une couche barrière 302 est formée sur les poteaux isolants 380 et les portions non recouvertes de la couche initiale isolante 322 ; puis une couche d'accroché 303 en un matériau métallique est formée sur cette couche barrière.

La couche barrière 302 comprend un matériau adapté à bloquer la diffusion de matériau métallique et/ou conducteur dans le matériau diélectrique, par exemple du nitrure de titane (TiN), éventuellement utilisé en bicouche avec du titane (TiN/Ti) ou une bicouche de nitrure de tantale et de tantale (TaN/Ta). Sonépaisseur est par exemple comprise entre environ 5 et 300 nm, par exemple égale à environ 10 nm.

La couche d'accroché 303 ("seed layer" en anglais) correspond à une couche d'initiation permettant la croissance ultérieure d'une couche conductrice par électrochimie. Elle est par exemple en cuivre, permettant l'obtention d'une couche conductrice en cuivre par électrochimie. Son épaisseur est par exemple comprise entre environ 1 nm et 300 nm, par exemple égale à environ 90 nm.

On procède ensuite à la croissance d'une couche conductrice 304 en un matériau conducteur, par exemple métallique, par exemple du cuivre, par électrochimie à partir de la couche d'accroché 303. La couche conductrice 304 a par exemple une épaisseur comprise entre 100 nm et 3 µm, par exemple égale à 1 µm. Le matériau conducteur de la couche 304 vient notamment remplir les tranchées 306.

Alternativement, la couche conductrice 304 peut être en un autre métal, par exemple du cobalt (Co) ou en un alliage métallique. Le matériau de la couche d'accroché est alors adapté pour obtenir la couche conductrice souhaitée.

La structure obtenue est ensuite polie ("planarisée") afin d'enlever une partie excédentaire de la couche conductrice 304 de manière à définir une surface plane dans laquelle le matériau conducteur dans les tranchées 306 affleure au même niveau que les poteaux isolants 380. Le matériau conducteur dans les tranchées 306 définit les plots conducteurs 34. En outre, l'étape de polissage peut avantageusement supprimer une portion de la couche en matériau barrière 302 située sur les poteaux isolants. L'étape de polissage consiste par exemple en un polissage mécanochimique (connu sous le terme "CMP" ou "Chemical Mechanical Polishing" en anglais).

A l'issue de l'étape de polissage, une première partie 304A de la couche conductrice forme des plots conducteurs 34 entre les poteaux isolants 380, deux plots conducteurs étant ainsi isolés électriquement, et une deuxième partie 304B de la couche conductrice s'étend de part et d'autre de l'alternance de plots conducteurs 34 et des poteaux isolants 380. La zone d'alternance de plots conducteurs 34 et de poteaux isolants 380 définit le site d'assemblage 31 du circuit électronique 30. Ainsi, la deuxième partie 304B de la couche conductrice s'étend de part et d'autre du site d'assemblage 31, et remplit une zone dite périphérique 39 audit site d'assemblage.

On procède ensuite, comme illustré en figure 3D, à la suppression de cette deuxième partie 304B de la couche conductrice, ainsi qu'une autre portion 302B de la couche barrière 302 située sous ladite deuxième partie de la couche conductrice.

On procède pour cela par gravure à travers un motif complémentaire 305 en résine (deuxième masque de gravure) formé sur la surface supérieure 31S du site d'assemblage 31. Le motif complémentaire est de préférence exempt de trous. Le motif complémentaire est, par exemple, formé par photolithographie.

Le motif complémentaire 305 recouvre complètement le site d'assemblage 31. Selon un mode de réalisation avantageux, et comme représenté dans la figure 3D, le motif complémentaire 305 peut déborder légèrement, d'une dimension par exemple comprise entre environ 1 nm et 1 µm, par exemple environ 300 nm, au-delà de la surface supérieure 31S du site d'assemblage 31. Ce débord permet d'éviter que, lors de l'une et/ou l'autre des deux étapes suivantes de gravure, les poteaux isolants 380 situés sur les bords 31A, 31B du site d'assemblage 31 ne subissent également une gravure, même partielle.

La gravure de la deuxième partie 304B de la couche conductrice est de préférence une gravure humide, par exemple à l'aide d'une solution composée d'un mélange de d'acide sulfurique (H₂SO₄) et de peroxyde d'hydrogène (H₂O₂).

La gravure de la portion 302B de la barrière de diffusion 302 peut être une gravure sèche, notamment mettant en oeuvre un plasma, ou une gravure humide, notamment à l'aide d'une solution de type "SC1" comprenant de l'ammoniaque et de l'eau oxygénée.

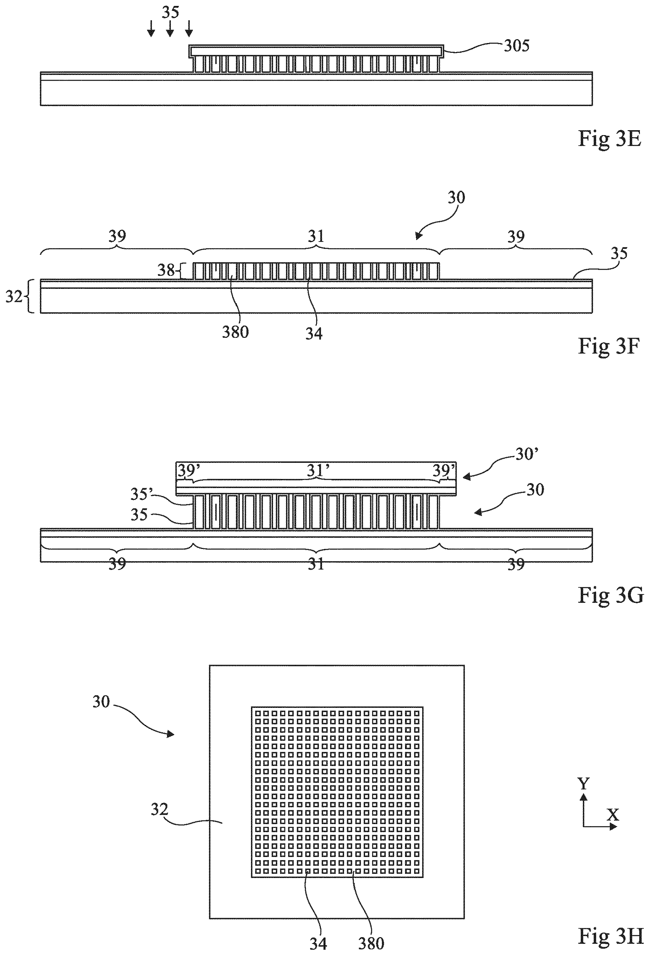

La figure 3E illustre une étape ultérieure, optionnelle, de formation d'une couche 35 en matériau hydrophobe ("couche hydrophobe"). Cette couche hydrophobe permet d'augmenter la différence de mouillabilité entre le site d'assemblage 31 et la zone périphérique 39 qui l'entoure. La couche 35 de matériau hydrophobe peut être déposée par enduction centrifuge ("spin coating" en anglais) ou par une technique de dépôt en phase vapeur. Son épaisseur est typiquement comprise entre environ 1 nm et 300 nm.

Le matériau hydrophobe peut être un matériau fluoré, de préférence fluorocarboné. A titre d'exemple, le matériau hydrophobe est à base de composés fluorocarbonés de type CₓF_{y}, où x et y sont des nombres réels, x pouvant varier de 1 à 5 et y pouvant varier de 1 à 8.

La figure 3F illustre le circuit électronique 30 obtenu après retrait du motif complémentaire 305.

Dans le cas où une étape de formation d'une couche en matériau hydrophobe a été réalisée, cette étape permet également de retirer la partie de la couche hydrophobe formée sur ledit motif complémentaire, selon un effet dit "lift-off".

Le circuit électronique 30 obtenu présente un site d'assemblage 31 sur le support 32, le site d'assemblage comportant des plots conducteurs 34 s'étendant sensiblement verticalement dans le site d'assemblage, deux plots conducteurs adjacents étant isolés entre eux par un poteau isolant 380. Le site d'assemblage 31 est adapté pour être assemblé à un autre circuit électronique par un procédé d'auto-assemblage incluant une étape de fixation hybride, par exemple une étape de collage moléculaire hybride ou par thermocompression.

De manière optionnelle, la zone périphérique 39 du support 32 entourant le site d'assemblage 31 est revêtue d'une couche hydrophobe 35, afin de diminuer sa mouillabilité par rapport au site d'assemblage 31 et favoriser le confinement d'une goutte de liquide sur le site d'assemblage. D'autres solutions peuvent être mises en oeuvre pour augmenter cette différence de mouillabilité. On peut par exemple augmenter l'hydrophilie de la surface d'assemblage par un traitement de surface adapté, par exemple à l'aide d'un plasma UV/Ozone.

La figure 3G est une vue en coupe illustrant un procédé d'auto-assemblage d'un premier circuit électronique 30 et d'un deuxième circuit électronique 30', lesdits circuits électroniques étant obtenus par un procédé de fabrication selon l'exemple décrit en relation avec les figures 3A à 3F. Ils peuvent alternativement être pour l'un et/ou l'autre obtenus par un autre procédé décrit ultérieurement. Comme représenté, le deuxième circuit électronique 30' peut être découpé, par exemple pour former une puce, avant d'être assemblé au premier circuit électronique 30.

Les étapes du procédé d'auto-assemblage ne sont pas illustrées, mais elles comprennent typiquement :
- une étape de dépôt d'une goutte d'un liquide, par exemple une goutte d'eau, sur le site d'assemblage 31 du premier circuit électronique 30 ;
- une étape dans laquelle le deuxième circuit électronique 30' est approché du site d'assemblage 31 du premier circuit électronique 30 jusqu'à ce que son site d'assemblage 31' vienne au contact de la goutte ; puis, une fois le deuxième circuit électronique 30' aligné sur le premier circuit électronique 30 :
- une étape de fixation hybride du deuxième circuit électronique 30' au premier circuit électronique 30 après évaporation du liquide, la fixation étant réalisée de préférence par collage moléculaire hybride ou par thermocompression.

Il est possible, après fixation, de retirer la couche hydrophobe 35, 35' formée sur chaque zone périphérique, par exemple par une gravure sèche.

Le procédé de fabrication, en définissant en une seule étape de photolithographie les bords du site d'assemblage et les emplacements des plots conducteurs dans ledit site, permet d'assurer un très bon alignement à la fois des sites d'assemblage et des plots conducteurs entre deux circuits électroniques fabriqués selon ledit procédé de fabrication.

Il est à noter que, dans l'ensemble des figures qui sont des vues en coupe, les bords du site d'assemblage sont représentés selon la direction X, mais de manière évidente, les bords sont également dans la direction Y du plan principal XY du circuit électronique. Le circuit électronique peut présenter une structure sensiblement symétrique dans les deux directions du plan, comme représenté dans la figure 3H, dans laquelle on voit en vue de dessus les poteaux isolants 380, les plots conducteurs 34 et le support 32 autour.

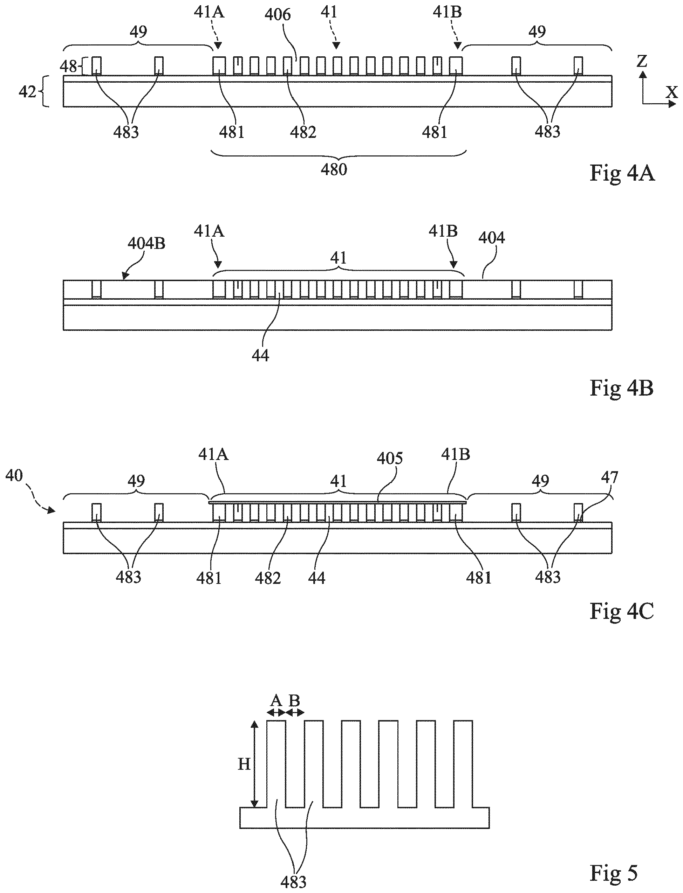

Les figures 4A à 4C sont des vues en coupe illustrant un procédé selon un autre mode de réalisation. Comme illustré en figure 4A, cet exemple se distingue du procédé précédent, en ce que :
- les poteaux isolants 480 comprennent des poteaux isolants 481 localisés sur les bords 41A, 41B du site d'assemblage 41 présentant une largeur supérieure à des poteaux isolants 482 situés entre lesdits bords ; et/ou
- des poteaux complémentaires 483 en matériau diélectrique sont également formés dans la zone périphérique 49 entourant le site d'assemblage 41 de même dimension que les poteaux isolants 482 ou de dimensions supérieures.

Les autres étapes du procédé de fabrication sont similaires à celles décrites en relation avec les figures 3A à 3F.

Comme illustré dans la figure 4B illustrant la structure obtenue à l'issue de l'étape de polissage, la présence de poteaux complémentaires 483 en matériau diélectrique permet de limiter, voire d'éviter, le phénomène de creusement (connu sous le terme « dishing » en anglais) de la deuxième partie 404B de la couche conductrice s'étendant de part et d'autre du site d'assemblage 41, phénomène qui peut se produire lors de l'étape de polissage sur des zones de cuivre de dimensions trop importantes, et qui peut induire une mauvaise définition des bords du site d'assemblage. Par ailleurs, le changement de densité de cuivre entre le site d'assemblage et la zone périphérique peut occasionner un dishing également au niveau des plots conducteurs en bordure du site d'assemblage pouvant entrainer un mauvais contact au moment de l'assemblage et une absence de collage pendant l'étape de fixation. La présence des poteaux complémentaires 483 ainsi que de poteaux isolants 481 localisés sur les bords 41A, 41B du site d'assemblage 41 de largeur supérieure aux poteaux isolants 482 situés entre lesdits bords va permettre de limiter, voire supprimer ce phénomène.

Comme illustré en figure 4C, après gravure de la deuxième partie 404B de la couche conductrice, les poteaux complémentaires 483 restent présents dans la zone périphérique 49 entourant le site d'assemblage 41. Il est possible à ce stade soit de les conserver, soit de les supprimer.

Les poteaux complémentaires 483 peuvent en effet être supprimés par effet lift-off par une gravure humide de la couche d'arrêt de gravure 47. Lors d'une telle étape de gravure, les portions de la couche d'arrêt de gravure localisées aux bords 41A, 41B du site d'assemblage 41 et/ou les poteaux d'extrémité 481 peuvent subir une gravure au moins partielle. Il est donc avantageux pour pallier ce problème que les poteaux d'extrémités 481 présentent une largeur supérieure aux poteaux centraux 482.

Alternativement, les poteaux complémentaires 483 peuvent être conservés et servir à augmenter la différence de mouillabilité entre le site d'assemblage et la zone périphérique (en complément ou de manière alternative à une couche de matériau hydrophobe déposée sur la zone périphérique). Pour cela, les poteaux complémentaires 483 doivent être formés de manière à respecter des plages données de dimensions et d'écartements entre deux poteaux complémentaires adjacents, comme cela est illustré en figure 5. Le motif en résine est alors défini pour respecter ces plages de dimensions et d'écartements, et l'épaisseur du matériau diélectrique est également définie pour respecter une hauteur définie des poteaux complémentaires. De manière préférentielle, la hauteur H des poteaux complémentaires 483 est comprise entre environ 50 nm et 2 µm, la largeur A des poteaux complémentaires est comprise entre environ 0,5 µm et 1 µm et l'écartement B entre deux poteaux complémentaires adjacents est compris entre environ 0,5 µm et 2 µm.

Après retrait du motif complémentaire 405, on obtient le circuit électronique 40.

Le procédé d'auto-assemblage décrit en lien avec la figure 3G peut s'appliquer à des premier et deuxième circuits électroniques obtenus par cet autre exemple de procédé de fabrication.

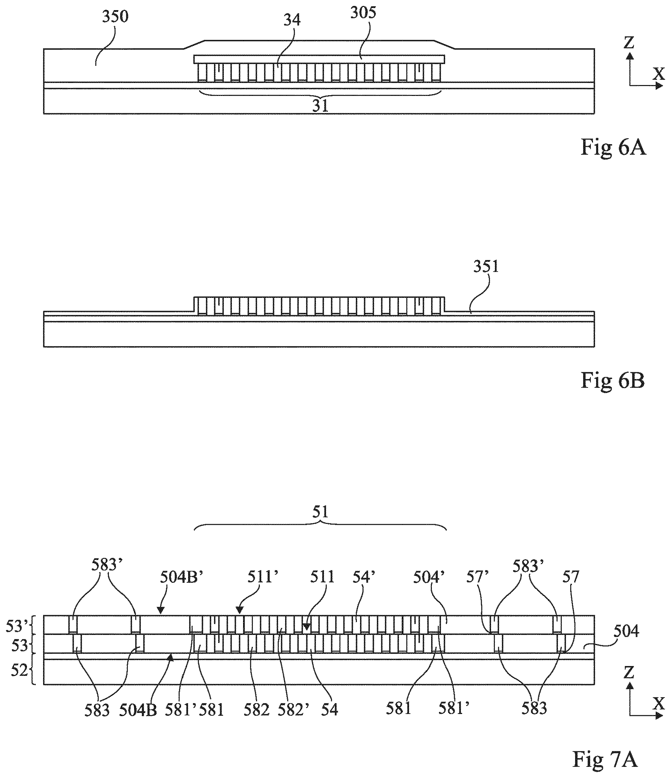

Les figures 6A et 6B sont des vues en coupe illustrant un autre mode de réalisation qui se distingue du procédé décrit en relation avec les figures 3A à 3F principalement par les étapes de formation de la couche 35 en matériau hydrophobe et de retrait du motif complémentaire 305 en résine. On part ainsi de la structure obtenue en figure 3D.

Comme illustrée en figure 6A, une couche 350 en matériau hydrophobe est formée sur cette structure. Contrairement au mode de réalisation précédent, cette couche hydrophobe 350 présente une épaisseur supérieure à celle de la protubérance du site d'assemblage 31 de sorte à la recouvrir.

La couche hydrophobe 350 a typiquement une épaisseur comprise entre environ 300 nm et 3 µm. Elle peut être formée selon des techniques similaires à celles décrites en relation avec la couche hydrophobe 35 de la figure 3E et être formée des mêmes matériaux.

L'étape de retrait du motif complémentaire 305 en résine formant la structure illustrée dans la figure 6B, est de préférence réalisée en mettant en œuvre une gravure sèche, de préférence au moins partiellement sélective par rapport au matériau conducteur des plots conducteurs 34, éventuellement suivie d'une étape de chimie liquide pour éliminer les résidus de résine photosensible. Une telle étape de retrait est mise en oeuvre pour graver à la fois le matériau hydrophobe et la résine. La gravure sèche peut être une gravure mettant en oeuvre un plasma, notamment un plasma à base de diazote et de dihydrogène (N₂/H₂).

A l'issue de cette étape de retrait du motif complémentaire 305, l'épaisseur de la couche hydrophobe 351 est réduite, par exemple comprise entre environ 100 et 400 nm, avantageusement entre environ 10 nm et 40 nm.

Le circuit électronique 30 obtenu, illustré dans la figure 6B, est sensiblement similaire au circuit électronique illustré dans la figure 3F.

Cet autre procédé de fabrication permet d'assurer qu'une couche suffisante de matériau hydrophobe soit formée sur l'ensemble de la zone périphérique 39 entourant le site d'assemblage 31, y compris sur les bords latéraux du site d'assemblage 31, et ce, malgré la présence du débord du motif complémentaire 305 en résine. En outre, une telle épaisseur de matériau hydrophobe permet d'avoir une plus grande marge sur la consommation de ce dernier lors des différentes étapes du procédé qui sont susceptibles de le dégrader. On peut ainsi se permettre de combiner plusieurs traitements de surface ou d'appliquer des temps de traitement plus longs, notamment pour augmenter la mouillabilité du site d'assemblage.

Les figures 7A à 7D sont des vues en coupe illustrant un autre mode de réalisation. Il se distingue des procédés précédents, en ce qu'il permet de former un site d'assemblage en plusieurs niveaux. Ceci permet d'augmenter la hauteur du site d'assemblage et favoriser le confinement d'une goutte de liquide sur ledit site lors de l'auto-assemblage de deux circuits électroniques.

On part pour cet exemple de la structure obtenue à la figure 4B (mode illustré) ou 3C (mode non illustré). On dispose ainsi d'un support 52 et d'un premier niveau 53 de site d'assemblage 511 sur le support 52, ledit premier niveau présentant une surface sensiblement plane, ledit site d'assemblage 511 du premier niveau 53 comportant des premiers plots conducteurs 54 (issus d'une première couche conductrice 504) disposés entre des premiers poteaux isolants 581, 582 et formant le premier niveau du site d'assemblage 51. Des premiers poteaux complémentaires 583 en matériau diélectrique sont, par exemple, disposés dans la zone périphérique 59 du site d'assemblage.

Comme illustré sur la figure 7A, on dispose sur la structure une deuxième couche d'arrêt de gravure 57'. On réitère ensuite le procédé décrit en lien avec les figures 3A à 3C ou 4A et 4B pour réaliser sur la couche d'arrêt 57' un deuxième niveau 53' de site d'assemblage 511', ledit deuxième niveau présentant une surface sensiblement plane, ledit site d'assemblage 511' du deuxième niveau 53' comportant des deuxièmes plots conducteurs 54' (issus d'une deuxième couche conductrice 504') disposés entre des deuxièmes poteaux isolants 582', 581', les deuxièmes plots conducteurs 54' et les deuxièmes poteaux isolants 581', 582' étant situés respectivement sensiblement au droit des premiers plots conducteurs 54 et des premiers poteaux isolants 581, 582. Le site d'assemblage 511' du deuxième niveau 53' forme le deuxième niveau du site d'assemblage 51.Des deuxièmes poteaux complémentaires 583' en matériau diélectrique sont, par exemple, disposés dans la zone périphérique 59 du site d'assemblage, sensiblement au droit des premiers poteaux complémentaires.

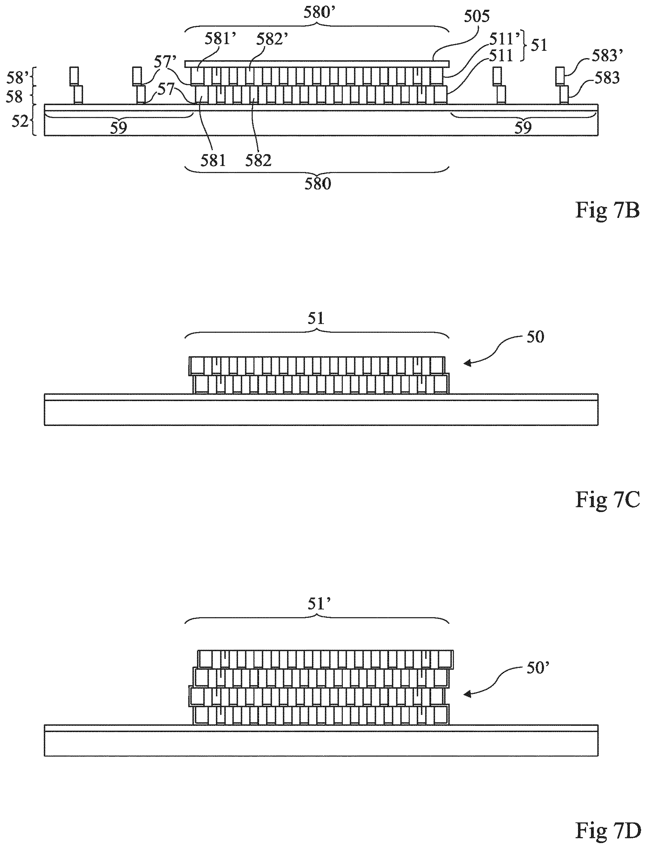

La figure 7B illustre la formation d'un motif complémentaire 505 en résine sur le deuxième niveau 511' du site d'assemblage 51. Ce motif va servir de masque pour la gravure de la deuxième partie 504B' de la deuxième couche conductrice 504' et d'une portion d'une deuxième couche barrière (non représentée) ainsi que de la deuxième partie 504B de la première couche conductrice 504 et d'une portion d'une première couche barrière (non représentée) jusqu'à déboucher dans le support 52.

Il est possible à ce stade éventuellement de retirer les poteaux complémentaires 583, 583' et/ou de former une couche en matériau hydrophobe sur la structure.

Comme illustré en figure 7C, à l'issue de l'étape de retrait du motif complémentaire 505, on obtient un circuit électronique 50 comportant un site d'assemblage 51 à deux niveaux sur un support 52.

L'ensemble des étapes décrites en relation avec la figure 7A, peut être réitéré, autant de fois que nécessaire, avant de mettre en œuvre les étapes décrites en relation avec la figure 7B, afin d'obtenir un circuit électronique 50' avec un site d'assemblage 51' à plus de deux niveaux, comme illustré en figure 7D.

Selon des variantes de réalisation, on peut adapter les étapes de cet autre exemple de procédé de réalisation pour intégrer des variantes des exemples précédents.

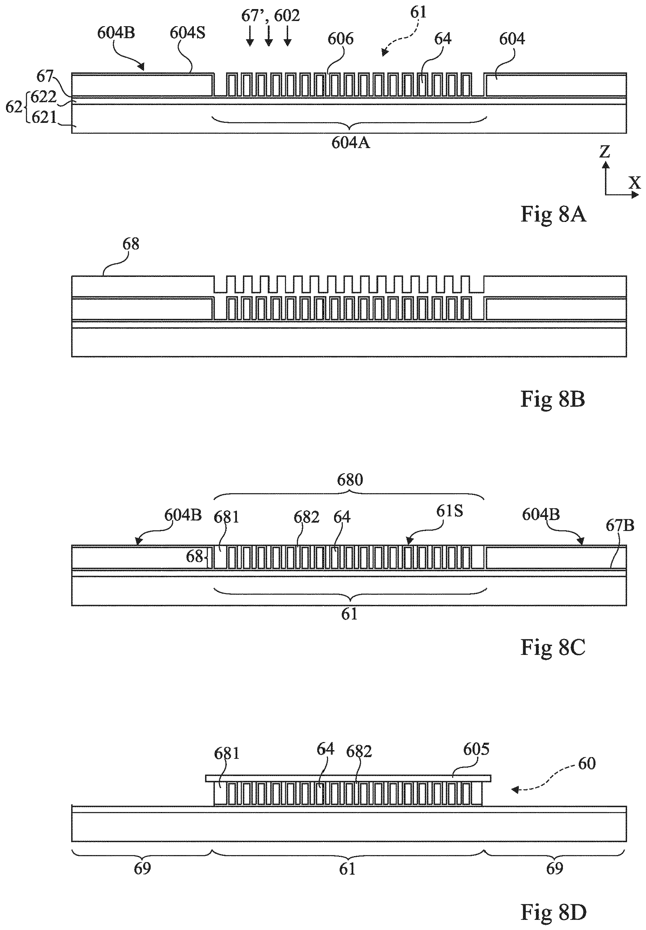

Les figures 8A à 8D sont des vues en coupe illustrant un procédé de fabrication selon autre mode de réalisation, mettant également en œuvre un procédé Damascène, qui se distingue principalement des exemples décrits précédemment en ce que le site d'assemblage, y compris les plots conducteurs, est formé non pas par gravure d'une couche isolante, mais par gravure d'une couche conductrice, les étapes du procédé de fabrication étant adaptées en conséquence.

Cet autre exemple de procédé de fabrication est particulièrement adapté pour former des plots conducteurs en aluminium (Al), mais peut également être mis en œuvre pour former des plots en un autre métal, par exemple en titane (Ti) ou tungstène (W), ou en un alliage métallique, par exemple un alliage à base d'aluminium et cuivre (AlCu), ou en un alliage d'aluminium et de silicium (AlSi).

La structure de départ comprend un support 62 comportant un substrat 621 revêtu d'une couche initiale en matériau diélectrique 622. Le support 62 est revêtu d'une couche 67 d'arrêt de gravure, elle-même revêtue d'une couche conductrice 604, par exemple une couche en un matériau métallique. Le substrat est par exemple en silicium (Si). Le matériau diélectrique est par exemple en dioxyde de silicium (SiO₂). La couche d'arrêt de gravure est par exemple en nitrure de silicium (SiₓN_{y}). La couche conductrice peut être déposée par une technique de dépôt chimique en phase vapeur, notamment par une technique de dépôt chimique en phase vapeur assisté par plasma (PECVD pour "Plasma-Enhanced Chemical Vapor Déposition" en anglais). Elle est par exemple en aluminium. Son épaisseur est par exemple comprise entre 50 nm et 2 µm, par exemple égale à 500 nm.

Comme illustrée en figure 8A, la couche conductrice 604 est ensuite structurée, en utilisant un motif (ou troisième masque de gravure, non illustré) formé d'une succession de créneaux pleins séparés par des trous, dans cet exemple formé par photolithographie, puis en gravant ladite couche conductrice à travers ledit motif, pour former des tranchées 606 dans ladite couche conductrice.

La gravure de la couche conductrice peut être une gravure sèche ou humide, par exemple une gravure mettant en œuvre en œuvre une solution de chlorure de fer (FeCl₃) dans le cas de la gravure de l'aluminium.

Ainsi, la partie centrale 604A (première partie) de la couche conductrice est conformée en une pluralité de plots conducteurs 64 entre deux tranchées 606, et la partie périphérique 604B (deuxième partie) de la couche conductrice n'est, elle, pas gravée.

La pluralité de tranchées 606 définit les contours du futur site d'assemblage 61 du circuit électronique 60, et les tranchées 606 définissent les emplacements des futurs poteaux isolants entre deux plots conducteurs 64, comme ceci est décrit plus après.

Ainsi, les bords du site d'assemblage et les emplacements des plots conducteurs sont définis lors de cette étape de photolithographie, c'est-à-dire avec un même niveau de photolithographie.

On dispose ensuite sur la structure :
- une couche complémentaire d'arrêt de gravure 67', par exemple en nitrure de silicium (SiₓN_{y}), formée sur les plots conducteurs 64, sur la partie périphérique 604B de la couche conductrice, et dans les tranchées 606 ; et
- une couche barrière 602 formée sur la couche complémentaire d'arrêt de gravure 67'.

La couche barrière 602 comprend, par exemple, un matériau adapté pour bloquer la diffusion du matériau conducteur dans le matériau diélectrique qui va être déposé ensuite. Elle est par exemple en nitrure de titane (TiN), éventuellement en bicouche avec du titane (TiN/Ti) ou en une bicouche de nitrure de tantale et de tantale (TaN/Ta).

La figure 8B illustre la formation d'une couche en matériau diélectrique 68 (couche isolante) sur la couche barrière 602, afin notamment de remplir les tranchées 606. Le matériau diélectrique est par exemple en dioxyde de silicium (SiO₂). La couche isolante peut être déposée par un dépôt chimique en phase vapeur, notamment par PECVD. Son épaisseur doit être plus élevée que (ou égale à) la profondeur des tranchées 606 afin de les combler, elle est par exemple comprise entre environ 50 et 3 µm, par exemple égale à environ 1 µm.

La figure 8C illustre la structure obtenue à l'issue d'une étape ultérieure de polissage permettant d'enlever une partie excédentaire de la couche isolante 68 de manière à définir une surface plane dans laquelle le matériau diélectrique 68 dans les tranchées 606 affleure au même niveau que les plots conducteurs 64. L'étape de polissage consiste par exemple en un polissage mécanochimique (CMP).

A l'issue de l'étape de polissage, la structure obtenue comprend une alternance de plots conducteurs 64 et de poteaux isolants 680, définissant le site d'assemblage 61 du circuit électronique 60, les plots conducteurs 64 et les poteaux isolants 680 pouvant présenter respectivement entre eux des dimensions égales ou différentes.

Comme illustré à la figure 8D, on procède ensuite à la suppression de la partie périphérique 604B de la couche conductrice située de part et d'autre du site d'assemblage 61 ainsi qu'à la portion résiduelle 67B de la première couche d'arrêt de gravure 67 localisée sous cette partie périphérique 604B. Cette suppression est réalisée par gravure au travers un motif complémentaire 605 en résine formé sur la surface supérieure 61S du site d'assemblage 61, par exemple par photolithographie.

Comme décrit précédemment, le motif complémentaire 605 recouvre entièrement le site d'assemblage 61, voire il peut déborder légèrement au-delà de la surface supérieure 61S du site d'assemblage 61.

La gravure de la partie périphérique 604B de la couche conductrice est de préférence une gravure humide, par exemple mettant en œuvre une solution chimique composée d'acide phosphorique (H₃PO₄), d'acide acétique, d'acide nitrique (HNO₃) et d'eau (H₂O).

La gravure de la partie résiduelle 67B de la première couche d'arrêt de gravure 67 peut être une gravure humide, notamment à l'aide de d'une solution chimique à base d'acide phosphorique (H₃PO₄).

Le procédé de fabrication peut comprendre des variantes décrites en lien avec les autres procédés (réalisation d'une couche hydrophobe et/ou de poteaux complémentaires dans la zone périphérique, site d'assemblage à plusieurs niveaux ...) .

Le circuit électronique 60 obtenu présente un support 62 et un site d'assemblage 61 sur le support, le site d'assemblage 61 comportant des plots conducteurs 64 s'étendant sensiblement verticalement dans le site d'assemblage, deux plots conducteurs adjacents étant isolés par deux poteaux isolants 680. Le site d'assemblage 61 est adapté pour être assemblé à un autre circuit électronique par un procédé d'auto-assemblage incluant une étape de fixation hybride. La zone périphérique 69 du support 62 entourant le site d'assemblage 61 du circuit électronique 60 peut être revêtue d'une couche de matériau hydrophobe et/ou comprendre des poteaux complémentaires.

Pour l'ensemble des exemples de réalisation, et de manière plus générale pour un circuit électronique obtenu par un procédé de fabrication selon un mode de réalisation, les dimensions suivantes peuvent être comprises dans les plages suivantes :
- hauteurs des poteaux isolants (ou hauteurs des plots conducteurs) : 50 nm à 2 µm ;
- largeurs des poteaux isolants : 10 nm à 100 µm ;
- largeurs des plots conducteurs : 10 nm à 100 µm ;
- épaisseur de la couche en matériau hydrophobe : 1 nm à 2 µm.

Pour l'ensemble des exemples de réalisation:
- l'étape (ou les étapes) de formation de la (ou des) couche(s) d'arrêt de gravure peut (peuvent) être omise(s) ; ou
- la (première) couche d'arrêt de gravure peut être formée entre le substrat et la couche initiale isolante ; ou
- la (première) couche d'arrêt peut être formée sur un niveau du substrat, par exemple entre deux couches de substrat.

Plus généralement, une couche d'arrêt de gravure peut être disposée à un niveau correspondant à la profondeur de gravure souhaitée.

Dans certains cas, la couche initiale isolante peut être omise et/ou la couche initiale isolante et la (première) couche isolante peuvent être une seule couche isolante (monocouche ou structure multicouches).

En outre, pour des procédés similaires aux procédés de fabrication décrits en relation avec les figures 3 à 7, l'étape de gravure de la couche isolante peut comprendre ou être suivie de la gravure de la couche initiale isolante et/ou de la gravure du substrat sur une profondeur donnée. De même, pour des procédés similaires au procédé de fabrication décrit en relation avec les figures 8, l'étape de gravure de la couche conductrice peut comprendre ou être suivie de la gravure de la couche initiale isolante et/ou de la gravure d'au moins une partie du substrat. Ceci est avantageux lorsqu'on souhaite une hauteur de site d'assemblage plus importante, notamment supérieure à 500 µm.

Il ressort de l'ensemble des modes, exemples et variantes de réalisation que le procédé de fabrication, en définissant les bords du site d'assemblage et les emplacements (incluant des dimensions dans au moins une direction du plan principal) des plots conducteurs avec un même motif, par exemple en un même niveau de photolithographie, permet d'éviter le risque de désalignement qui existe lorsque deux motifs, par exemple deux niveaux de photolithographie, sont mis en œuvre pour dessiner d'une part les emplacements des plots conducteurs et d'autre part les bords du site d'assemblage. Ainsi, on assure un très bon alignement à la fois des sites d'assemblage et des plots conducteurs entre deux circuits électroniques. En outre, cela permet de simplifier la formation du site d'assemblage. De plus, le procédé est facilement adaptable, selon les circuits électroniques souhaités, en particulier selon les configurations souhaitées des sites d'assemblage et/ou des zones périphériques auxdits sites, ce qui peut être simplement réalisable en adaptant la forme et les dimensions du motif (ou des motifs lorsqu'il y a plusieurs niveaux de site d'assemblage).

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier :
- le circuit électronique peut comprendre sur le plan de son support plusieurs sites d'assemblage, notamment lorsque plusieurs autres circuits électroniques doivent être assemblés au circuit électronique ;
- les repères dans la couche isolante entre les plots conducteurs peuvent être omis.

## Revendications

1. Procédé de fabrication d'un circuit électronique (30, 40, 50, 50', 60) s'étendant selon un plan principal (XY), le procédé de fabrication comprenant :
- une étape de formation, par un procédé Damascène à l'aide d'un motif (301), d'un site d'assemblage (31, 41, 51, 61) sur un support (32, 42, 52, 62), le site d'assemblage étant formé d'une alternance de plots conducteurs (34, 44, 54, 54', 64) en un matériau conducteur et de poteaux isolants (380, 480, 580, 580', 680) en un matériau diélectrique affleurant à une première surface (31S, 61S) du site d'assemblage, le site d'assemblage étant délimité par des poteaux isolants et entouré d'une zone périphérique (39, 49, 59, 69) comportant une partie (304B, 404B, 504B, 504B', 604B) du matériau conducteur ;
- une étape de formation d'un deuxième masque de gravure (305, 405, 505, 605) recouvrant entièrement le site d'assemblage ;
- une étape complémentaire de gravure, à travers le deuxième masque de gravure, du matériau conducteur de la zone périphérique (39, 49, 59, 69), puis une étape de retrait du deuxième masque de gravure, de sorte que le site d'assemblage (31, 41, 51, 61) forme une protubérance par rapport au support (32, 42, 52, 62).

2. Procédé de fabrication selon la revendication 1, dans lequel l'étape de formation par un procédé Damascène du site d'assemblage (31, 41, 51) comprend :
- une étape de formation d'une couche isolante (38, 48, 58) en le matériau diélectrique sur le support (32, 42, 52) ;
- une étape de gravure de la couche isolante (38, 48, 58) à travers un premier masque de gravure en résine formant le motif (301) comprenant des parties pleines séparées par des trous de manière à former les poteaux isolants (380, 480, 580) en le matériau diélectrique séparés par des tranchées (306, 406) dans ladite couche isolante ; puis une étape de retrait du motif (301) ;
- une étape de formation d'une couche conductrice (304, 404, 504) en le matériau conducteur sur la face gravée de la couche isolante de manière à combler les tranchées, et par exemple recouvrir les poteaux isolants, le matériau conducteur inséré dans les tranchées formant les plots conducteurs (34, 44, 54) alternant avec les poteaux isolants ; puis
- une étape de polissage de la couche conductrice de manière à faire affleurer les plots conducteurs et les poteaux isolants au même niveau.

3. Procédé de fabrication selon la revendication 2, dans lequel le matériau conducteur est du cuivre ou du cobalt.

4. Procédé de fabrication selon la revendication 1, dans lequel l'étape de formation par un procédé Damascène du site d'assemblage (61) comprend :
- une étape de formation d'une couche conductrice (604) en le matériau conducteur sur le support (62) ;
- une étape de gravure de la couche conductrice (604) à travers un troisième masque de gravure en résine formant le motif et comprenant des parties pleines séparées par des trous de manière à former les plots conducteurs (64) en le matériau conducteur séparés par des tranchées (606); puis une étape de retrait du troisième masque de gravure;
- une étape de formation d'une couche isolante (68) en le matériau diélectrique sur la face gravée de la couche conductrice (604) de manière à combler les tranchées (606), et par exemple recouvrir les plots conducteurs, le matériau diélectrique inséré dans lesdites tranchées formant les poteaux isolants (680) isolant les plots conducteurs (64) entre eux ; puis
- une étape de polissage de la couche isolante (68) de manière à faire affleurer les plots conducteurs et les poteaux isolants au même niveau.

5. Procédé de fabrication selon la revendication 4, dans lequel le matériau conducteur est de l'aluminium, du tungstène, ou un alliage à base d'aluminium et de cuivre ou d'aluminium et de silicium.

6. Procédé de fabrication selon l'une des revendications 2 à 5, dans lequel la formation du site d'assemblage (31, 41, 51) comprend, préalablement à l'étape de formation de la couche isolante (38, 48, 58) sur le support (32, 42, 52) ou de la couche conductrice (604) sur le support (62), une étape de formation d'une couche d'arrêt de gravure (37, 47, 57, 67) sur le support (32, 42, 52, 62), par exemple une couche en nitrure de silicium.

7. Procédé de fabrication selon l'une des revendications 1 à 6, dans lequel le motif est dimensionné pour que les poteaux isolants (480, 580, 580', 680) comprennent des poteaux isolants (481, 581, 581', 681) aux bords du site d'assemblage (41, 51, 61) plus larges dans au moins une direction (X) du plan principal (XY) que les poteaux isolants (482, 582, 582', 682) situés entre lesdits bords.

8. Procédé de fabrication selon l'une des revendications 1 à 7, dans lequel le motif est dimensionné pour former sur la zone périphérique (49, 59) du support (42, 52) des poteaux complémentaires (483, 583) en le matériau diélectrique.

9. Procédé de fabrication selon la revendication 8, dans lequel les poteaux complémentaires (483) sont configurés pour diminuer la mouillabilité de la zone périphérique (49) par rapport à la mouillabilité du site d'assemblage (41), par exemple les poteaux complémentaires présentent une largeur (A) dans au moins une direction (X) du plan principal (XY) comprise entre 0,5 µm et 1 µm, une hauteur (H) comprise entre 50 nm et 2 µm, et deux poteaux complémentaires adjacents sont distants d'un écartement (B) compris entre 0,5 µm et 2 µm dans ladite direction.

10. Procédé de fabrication selon l'une des revendications 1 à 9, dans lequel les étapes de formation par un procédé Damascène du site d'assemblage (51) sont réitérées au moins une fois, avant l'étape de formation du deuxième masque de gravure, de manière à former un autre niveau (511') de site d'assemblage comprenant d'autres plots conducteurs (54') et d'autres poteaux isolants (580'), lesdits autres plots conducteurs, respectivement lesdits autres poteaux isolants, étant disposés sensiblement au droit des plots conducteurs, respectivement des poteaux isolants, du niveau (511) du site d'assemblage précédemment formé ; ledit procédé comprenant par exemple une étape préalable de formation d'une couche d'arrêt de gravure (57') sur le niveau du site d'assemblage précédemment formé.

11. Procédé de fabrication selon l'une des revendications 1 à 10, dans lequel le deuxième masque de gravure (305, 405, 505, 605) déborde d'une dimension par exemple comprise entre 1 nm et 1 µm, par exemple 300 nm, de part et d'autre dudit site d'assemblage au-dessus de la zone périphérique (39, 49, 59, 69).

12. Procédé de fabrication selon l'une des revendications 1 à 11, comprenant une étape, ultérieure à l'étape complémentaire de gravure, de formation d'une couche (35), d'épaisseur par exemple comprise entre 1 et 300 nm, en un matériau hydrophobe, sur la zone périphérique (39), le matériau hydrophobe étant par exemple un matériau fluoré, de préférence fluorocarboné.

13. Circuit électronique (30, 40, 50, 60) s'étendant selon un plan principal (XY) et comprenant :
- un support (32, 42, 52, 62) ;
- un site d'assemblage (31, 41, 51, 61) sur ledit support, ledit site d'assemblage présentant une première surface (31S, 61S) protubérante par rapport audit support destinée à être assemblé à un site d'assemblage (31') d'un autre circuit électronique (30') par un procédé d'auto-assemblage ; et
- une zone périphérique (39, 49, 59, 69) tout autour dudit site d'assemblage ;
le site d'assemblage (31, 41, 51, 61) comportant au moins un niveau (511, 511'), chaque niveau comportant une alternance de plots conducteurs (34, 44, 54, 54', 64) et de poteaux isolants (380, 480, 580, 580', 680) affleurant à une première surface dudit niveau du site d'assemblage, le site d'assemblage étant obtenu par le procédé de fabrication selon l'une des revendications 1 à 12, et étant délimité par des poteaux isolants.

14. Procédé d'auto-assemblage d'un premier circuit électronique (30) et d'un deuxième circuit électronique (30'), les premier et deuxième circuits électroniques étant fabriqués selon le procédé de fabrication selon l'une des revendications 1 à 13, le procédé d'auto-assemblage comprenant :
- une étape de dépôt d'une goutte d'un liquide sur la première surface (31S) du site d'assemblage (31) du premier circuit électronique (30) ; puis
- la mise en contact de la première surface du site d'assemblage (31') du deuxième circuit électronique (30') avec la première surface (31S) du site d'assemblage (31), revêtue de la goutte de liquide, du premier circuit électronique (30) ; puis
- une étape de fixation, par exemple par collage moléculaire hybride ou thermocompression, du site d'assemblage (31') du deuxième circuit électronique (30') au site d'assemblage (31) du premier circuit électronique (30) .

15. Procédé d'auto-assemblage selon la revendication 14, dans lequel le deuxième circuit électronique (30') est découpé de manière à former une puce de circuit intégré préalablement à l'étape de mise en contact, le premier circuit électronique (30) étant une plaque de circuits intégrés.
